# FASCICULE DE BREVET EUROPEEN

(11) **EP 1 713 958 B1**
(45) Date de publication et mention de la délivrance du brevet: **04.08.2010**
(21) Numéro de dépôt: 05717694.3
(22) Date de dépôt: 28.01.2005
(51) Int. Cl.: C30B 11/00

(54) **PROCEDE ET DISPOSITIF DE FABRICATION DE MONOCRISTAUX**
VERFAHREN UND VORRICHTUNG ZUR HERSTELLUNG VON EINKRISTALLEN
METHOD AND DEVICE FOR PRODUCING MONOCRYSTALS

(30) Priorité: 30.01.2004 FR 0450177
(43) Date de publication de la demande: 25.10.2006
(73) Titulaire: CENTRE NATIONAL DE LA RECHERCHE SCIENTIFIQUE (CNRS), 75794 Paris Cedex 16 (FR)
(72) Inventeur: DUFFAR, Thierry, F-38000 Grenoble (FR); FOURNIER-GAGNOUD, Annie, F-38330 SAINT ISMIER (FR)
(74) Mandataire: de Beaumont, Michel
(86) Numéro de dépôt international: PCT/FR2005/050055
(87) Numéro de publication internationale: WO 2005/078166

(56) Documents cités:
- EP-A- 1 167 586
- FR-A- 2 757 184
- FR-A- 2 806 100
- US-A- 3 096 158
- US-A1- 2002 121 237
- PATENT ABSTRACTS OF JAPAN vol. 0081, no. 06 (C-223), 18 mai 1984 (1984-05-18) & JP 59 021593 A (MATSUSHITA DENKI SANGYO KK), 3 février 1984 (1984-02-03)
- PATENT ABSTRACTS OF JAPAN vol. 0186, no. 10 (C-1276), 21 novembre 1994 (1994-11-21) & JP 06 234590 A (FURUKAWA ELECTRIC CO LTD:THE), 23 août 1994 (1994-08-23)

## Description

La présente invention concerne un procédé et un dispositif de fabrication de monocristaux par solidification d'un liquide mis en présence d'un solide monocristallin.

Une application de la présente invention concerne un dispositif de fabrication de monocristaux comprenant un creuset dans lequel sont placés un germe du monocristal à former et une phase liquide du cristal. Le liquide est progressivement refroidi à partir de la région à proximité du germe. Le liquide se solidifie d'abord près du germe, puis l'interface liquide-solide se déplace à l'intérieur du creuset jusqu'à ce que la solidification soit complète. Comme le solide nouvellement formé reproduit la structure cristallographique du solide adjacent formé auparavant, le germe impose de proche en proche sa structure cristallographique à l'ensemble du contenu du creuset.

Un problème d'un tel procédé est cependant lié aux différences de dilatations thermiques entre le creuset et le cristal qu'il contient. En effet, si le creuset se contracte plus que le cristal pendant le refroidissement, le monocristal risque d'être endommagé ou même fracturé. Il est, en outre, alors difficile d'extraire le monocristal du creuset, qui doit généralement être détruit. Si le cristal se contracte plus que le creuset, le cristal ne reste pas forcément intact non plus car il tend généralement à adhérer au creuset après la solidification, et risque donc de subir des contraintes de traction lors du refroidissement.

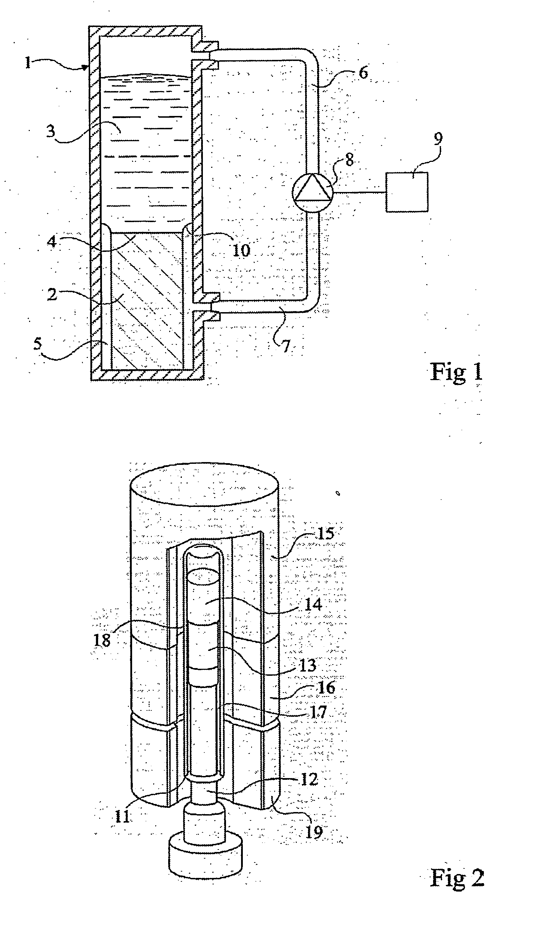

La figure 1 représente schématiquement un dispositif de fabrication de monocristaux qui ne présente pas l'inconvénient précédemment mentionné. Le dispositif comprend un creuset 1 cylindrique contenant une phase solide monocristalline 2 à sa partie inférieure et une phase liquide 3 à solidifier au dessus d'une interface 4 avec la phase solide 2. La phase liquide 3 baigne la paroi du creuset 1, tandis que la phase solide 2 est séparée de la paroi du creuset 1 par un interstice 5. Un conduit supérieur 6 débouche dans le creuset 1 au-dessus de la surface libre de la phase liquide 3, et un conduit inférieur 7 débouche également dans le creuset 1, au niveau de l'interstice 5. Les conduits 6 et 7 se réunissent au niveau d'un système 8 adapté à créer une pression différentielle de sorte que la pression injectée dans le conduit inférieur 7 est supérieure à celle du conduit supérieur 6 d'une valeur sensiblement égale à la pression hydrostatique de la phase liquide 3, c'est-à-dire à la pression produite par la hauteur de la colonne de liquide 3. L'interstice 5 apparaît spontanément dans ces conditions quand le cristal se solidifie, l'interface 4 se raccordant à la paroi du creuset 1 par un ménisque 10 au-dessus de l'interstice 5. Un tel exemple de dispositif de fabrication de monocristaux est décrit dans la demande de brevet français 2 757 184 déposée au nom du Commissariat à l'Energie Atomique.

La figure 2 représente un écorché partiel d'une variante du dispositif de fabrication de monocristaux de la figure 1 dans lequel le creuset 11 est constitué d'une ampoule hermétiquement scellée placée sur un support 12. Une phase solide 13 monocristalline est fixée au support 12 dans le creuset 11 et est recouverte d'une phase liquide 14. Un premier four 15 entoure le creuset 11 sensiblement en vis-à-vis de la phase liquide 14. Un deuxième four 16 entoure le creuset 11 sensiblement en vis-à-vis de la phase solide 13. Les premier et deuxième fours 15, 16 imposent un gradient de température localisé dans le creuset 11 entraînant la solidification de la phase liquide 14 au niveau de l'interface liquide-solide. Au fur et à mesure de la solidification de la phase liquide 14, le creuset hermétique 11 est déplacé par mouvement du support 12 de sorte que l'interface liquide-solide est sensiblement fixe par rapport aux premier et deuxième fours 15, 16 et se trouve en permanence au niveau du gradient de température. Un interstice 17 existe entre la phase solide 13 et le creuset 11. La phase liquide 14 relie la phase solide 13 au creuset 11 par un ménisque 18. L'interstice 17 est rempli d'un gaz neutre qui assure le maintien du ménisque 18. La pression du gaz neutre est fixée par l'intermédiaire d'un troisième four 19 qui chauffe la partie inférieure du creuset 11. Un tel exemple de dispositif de fabrication de monocristaux est décrit dans la demande de brevet français 2 806 100 déposée au nom du Commissariat à l'Energie Atomique.

Les dispositifs de fabrication de monocristaux précédemment décrits permettent d'éviter le contact entre le creuset et le monocristal. Toutefois, l'utilisation de tels dispositifs est délicate. En effet, la différence entre les pressions appliquées sur le ménisque 10, 18 et sur la surface libre de la phase liquide doit diminuer au fur et à mesure de la croissance du cristal puisque la hauteur de la colonne liquide 3, 14, et donc la pression hydrostatique résultante, diminue. En outre, le composant ou les composants constituant la phase liquide 3, 14 ont des tensions de vapeur qui peuvent être élevées. Ceci peut se traduire par des échanges gazeux non négligeables entre la phase liquide 3, 14 et le gaz environnant, au niveau du ménisque 10, 18 et au niveau de la surface libre de la phase liquide 3, 14. De tels échanges compliquent le contrôle du procédé de fabrication du monocristal puisqu'ils tendent à modifier la différence entre les pressions appliquées sur le ménisque 10, 18 et sur la surface libre de la phase liquide 3, 14. De plus, pour un monocristal comprenant plusieurs composants, de tels échanges gazeux tendent à modifier la proportion des composants dans la phase liquide 3, 14. Le monocristal obtenu peut alors ne pas avoir la composition souhaitée. Il est donc nécessaire de tenir compte des tensions de vapeur des composants de la phase liquide 3, 14 pour déterminer la différence de pression à appliquer, ce qui s'avère être très délicat en pratique, voire même contraire à l'obtention de l'interstice 5.

La présente invention vise à obtenir un dispositif de fabrication de monocristaux par solidification d'un liquide mis en présence d'un germe monocristallin ne présentant pas les inconvénients précédemment mentionnés.

Pour atteindre cet objet, la présente invention prévoit un dispositif de fabrication d'une phase solide monocristalline par solidification d'une phase liquide, comprenant un creuset adapté à contenir la phase solide et la phase liquide et dont au moins une paroi est destinée à être en contact avec la phase liquide, la phase solide étant séparée du creuset par un interstice ; un moyen de chauffage de la phase liquide adapté à créer un gradient thermique au niveau d'une interface entre la phase liquide et la phase solide ; et un moyen de génération d'un champ électromagnétique, distinct du moyen de chauffage, pour appliquer une pression électromagnétique sur la surface de jonction de la phase liquide au niveau de ladite interface comprenant au moins une spire entourant le creuset, et placée en vis-à-vis de la zone dans laquelle se forme en fonctionnement ladite interface.

Selon un mode de réalisation de la présente invention, le creuset est adapté à contenir la phase liquide disposée au dessus de la phase solide. Le dispositif comprend un moyen pour appliquer une première pression de gaz sur la surface de jonction et une seconde pression de gaz sur une surface libre de la phase liquide opposée à la phase solide, la première pression de gaz étant supérieure à la seconde pression de gaz.

La présente invention prévoit également un procédé de fabrication d'une phase solide monocristalline par solidification d'une phase liquide comprenant les étapes consistant à prévoir un creuset contenant la phase solide et la phase liquide, la phase liquide étant en contact avec le creuset, la phase solide étant séparée du creuset par un interstice ; à appliquer un gradient thermique au niveau d'une interface entre la phase liquide et la phase solide ; et à appliquer simultanément une pression électromagnétique sur toute la surface de jonction de la phase liquide au niveau de ladite interface.

Selon un mode de réalisation de l'invention, la phase liquide est située au dessus de la phase solide, le procédé consistant à appliquer une première pression de gaz sur la surface de jonction et une seconde pression de gaz sur une surface libre de la phase liquide opposée à la phase solide, la première pression de gaz étant supérieure à la seconde pression de gaz

Cet objet, ces caractéristiques et avantages, ainsi que d'autres de la présente invention seront exposés en détail dans la description suivante d'exemples de réalisation particuliers faite à titre non-limitatif en relation avec les figures jointes parmi lesquelles :
la figure 1, précédemment décrite, représente schématiquement un dispositif classique de fabrication de monocristaux ;
la figure 2, précédemment décrite, représente schématiquement une variante du dispositif de la figure 1 ;
la figure 3 représente schématiquement un exemple de réalisation du dispositif de fabrication de monocristaux selon l'invention ; et
la figure 4 représente schématiquement une variante de réalisation du dispositif de la figure 3.

Un exemple de réalisation de la présente invention va être décrit pour un dispositif de fabrication de monocristaux analogue à ceux représentés aux figures 1 et 2. Un tel dispositif de fabrication de monocristaux permet notamment d'obtenir des monocristaux semiconducteurs des familles II-VI (cristal de cadmium et de tellure CdTe) et III-V (cristal de gallium et d'arsenic GaAs, cristal d'indium et de phosphore InP, cristal de gallium et d'antimoine GaSb, cristal d'indium et d'antimoine InSb, etc...) .

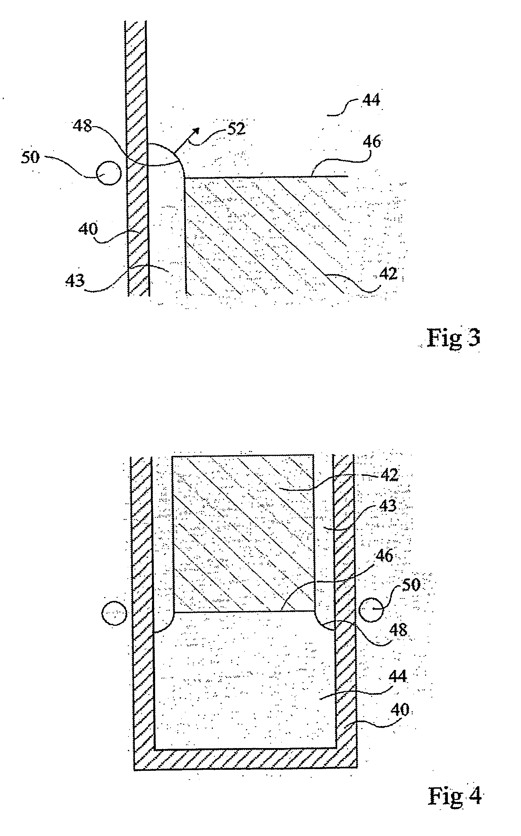

La figure 3 représente un creuset 40 contenant une phase solide monocristalline 42, séparée du creuset 40 par un interstice 43, et surmontée, selon la direction verticale, d'une phase liquide 44 à partir de laquelle est formé le monocristal. La phase liquide 44 est en contact avec la phase solide 42 au niveau d'une interface liquide-solide 46, et baigne le creuset 40. Au niveau de l'interstice 43, la phase liquide 44 est délimitée par un ménisque 48 qui s'étend entre l'interface liquide-solide 46 et le creuset 40.

Une spire 50 de section circulaire, disposée à l'extérieur du creuset 40, entoure le creuset 40 en vis-à-vis de l'interface liquide-solide 46. La spire 50 est traversée par un courant alternatif qui induit un champ électromagnétique, notamment au niveau du ménisque 48, ce qui se traduit par l'application d'une pression électromagnétique sur le ménisque 48. A titre d'exemple, la direction de la pression électromagnétique appliquée au niveau de la partie médiane du ménisque 48 est indiquée par une flèche 52 en figure 4. La pression électromagnétique est sensiblement de l'ordre de B²/2µ, où B est l'amplitude moyenne du champ électromagnétique au niveau du ménisque 48 et µ est la perméabilité magnétique de la phase liquide 44. La demanderesse a mis en évidence que lorsque la spire 50 est parcourue par un courant alternatif de 1000 ampères à 50 000 hertz, la pression électromagnétique appliquée sur la phase liquide 44 est suffisante pour former le ménisque 48 dans un interstice 43 de quelques dizaines de micromètres d'épaisseur et pour une pression hydrostatique de la colonne liquide 44 correspondant à une dizaine de centimètres de semiconducteur fondu même en l'absence d'une différence entre les pressions de gaz appliquées sur le ménisque 48 et sur la surface libre de la phase liquide 44. Ceci est particulièrement avantageux dans le cas où il est souhaitable de former le monocristal sous vide.

Lorsqu'on impose une différence entre les pressions appliquées sur le ménisque 48 et sur la surface libre de la phase liquide 44, un courant alternatif d'amplitude nettement inférieure à 1000 ampères est suffisant pour assurer la formation et le maintien du ménisque 48. Il peut être souhaitable de ne pas utiliser des champs électromagnétiques d'intensité trop élevées pour éviter un échauffement et/ou un brassage hydrodynamique trop important de la phase liquide 44, ce qui peut nuire à l'obtention d'un monocristal de bonne qualité. Il peut donc être préférable d'utiliser un procédé mettant en oeuvre simultanément une différence de pression de gaz comme pour les dispositifs représentés aux figures 1 ou 2, et la génération d'un champ électromagnétique localisé au niveau du ménisque 48. L'amplitude de la différence de pression de gaz et l'amplitude du champ électromagnétique présent au niveau du ménisque 48 sont notamment déterminées en fonction de la forme particulière du ménisque souhaitée. En particulier, la régulation de la différence de pression de gaz est facilitée par la présence de la pression électromagnétique qui participe à la formation et au maintien du ménisque 48.

La phase solide 42 peut être déplacée au fur et à mesure de la solidification de la phase liquide 44 de façon que l'interface liquide-solide 46 reste sensiblement fixe par rapport au creuset 40. La spire 50 est alors sensiblement fixe par rapport au creuset 40 en vis-à-vis de l'interface liquide-solide 46. Inversement, les moyens de chauffage des phases solide 42 et liquide 44 peuvent être mobiles par rapport au creuset 40 entraînant un déplacement de l'interface liquide-solide 46 relativement au creuset 40 au fur et à mesure de la solidification de la phase liquide 44. Le dispositif selon l'invention comprend alors un moyen, non représenté, pour déplacer la spire 50 de façon que la spire 50 se trouve en permanence, par rapport au creuset 40, au niveau de l'interface liquide-solide 46.

La figure 4 représente une variante de réalisation du dispositif de fabrication de monocristaux de la figure 3 dans lequel la phase liquide 44 est prévue dans le creuset 40 en dessous de la phase solide 42. Un moyen adapté, non représenté, maintient alors la phase solide 42 fixe par rapport au creuset 40. Un tel dispositif de fabrication de monocristaux est généralement appelé dispositif à croissance de Bridgman vertical inverse. Dans ce cas, le ménisque 48 a tendance à se former spontanément, sans pression de gaz. Le champ électromagnétique formé par la spire 50 permet de stabiliser et contrôler la forme du ménisque 48.

Dans les exemples de réalisation précédemment décrits, la spire utilisée est de section circulaire. La section de la spire peut être toutefois modifiée en fonction du champ électromagnétique que l'on souhaite obtenir. A titre d'exemple, la spire peut avoir une section "en pointe", la pointe étant orientée vers la surface de la phase liquide sur laquelle on souhaite appliquer une pression électromagnétique. Une telle section favorise l'augmentation de l'amplitude moyenne du champ électromagnétique au niveau de la surface de la phase liquide sur laquelle on souhaite appliquer la pression électromagnétique.

## Revendications

1. Dispositif de fabrication d'une phase solide monocristalline (42) par solidification d'une phase liquide (44), comprenant :
un creuset (40) adapté à contenir la phase solide (42) et la phase liquide (44) et dont au moins une paroi est destinée à être en contact avec la phase liquide, la phase solide étant séparée du creuset par un interstice (43) ; et
un moyen de chauffage de la phase liquide adapté à créer un gradient thermique au niveau d'une interface (46) entre la phase liquide et la phase solide,
**caractérisé en ce qu'**il comprend un moyen de génération d'un champ électromagnétique (50), distinct du moyen de chauffage, pour appliquer une pression électromagnétique sur la surface de jonction (48) de la phase liquide au niveau de ladite interface comprenant au moins une spire (50) entourant le creuset, et placée en vis-à-vis de la zone dans laquelle se forme en fonctionnement ladite interface.

2. Dispositif selon la revendication 1, dans lequel le creuset (40) est adapté à contenir la phase liquide (44) disposée au dessus de la phase solide (42), le dispositif comprenant en outre un moyen pour appliquer une première pression de gaz sur la surface de jonction (48) et une seconde pression de gaz sur une surface libre de la phase liquide (44) opposée à la phase solide (42), la première pression de gaz étant supérieure à la seconde pression de gaz.

3. Procédé de fabrication d'une phase solide monocristalline (42) par solidification d'une phase liquide (44) comprenant les étapes suivantes :
prévoir un creuset (40) contenant la phase solide (42) et la phase liquide (44), la phase liquide (44) étant en contact avec le creuset, la phase solide étant séparée du creuset par un interstice (43) ;
appliquer un gradient thermique au niveau d'une interface (46) entre la phase liquide et la phase solide ; et
appliquer simultanément une pression électromagnétique sur toute la surface de jonction (48) de la phase liquide au niveau de ladite interface.

4. Procédé selon la revendication 3, dans lequel la phase liquide (44) est située au dessus de la phase solide (42) et consistant à appliquer une première pression de gaz sur la surface de jonction (48) et une seconde pression de gaz sur une surface libre de la phase liquide (44) opposée à la phase solide (42), la première pression de gaz étant supérieure à la seconde pression de gaz.

## Claims

1. A device for manufacturing a single-crystal solid phase (42) by solidification of a liquid phase (44), comprising:
a crucible (40) capable of containing the solid phase (42) and the liquid phase (44), the liquid phase being in contact with the crucible and the solid phase being separated from the crucible by an interstice (43); and
means for heating the liquid phase capable of creating a thermal gradient at the level of an interface (46) between the liquid phase and the solid phase,
**characterized in that** it comprises electromagnetic field generation means (50), distinct from the heating means, for applying an electromagnetic pressure on the junction surface (48) of the liquid phase at the level of said interface comprising at least one spiral (50) surrounding the crucible, and placed opposite to the area in which said interface forms in operation.

2. The device of claim 1, in which the crucible (40) is capable of containing the liquid phase (44) arranged above the solid phase (42), the device further comprising means for applying a first gas pressure on the junction surface (48) and a second gas pressure on a free surface of the liquid phase (44) opposite to the solid phase (42), the first gas pressure being greater than the second gas pressure.

3. A method for manufacturing a single-crystal solid phase (42) by solidification of a liquid phase (44) comprising the steps of:
providing a crucible (40) containing the solid phase (42) and the liquid phase (44), the liquid phase (44) being in contact with the crucible, the solid phase being separated from the crucible by an interstice (43);
applying a thermal gradient at the level of an interface (46) between the liquid phase and the solid phase; and
simultaneously applying an electromagnetic pressure over the entire junction surface (48) of the liquid phase at the level of said interface.

4. The method of claim 3, wherein the liquid phase (44) is located above the solid phase (42) and consisting of applying a first gas pressure on the junction surface (48) and a second gas pressure on a free surface of the liquid phase (44) opposite to the solid phase (42), the first gas pressure being greater than the second gas pressure.

## Patentansprüche

1. Eine Vorrichtung zur Herstellung eines Einkristalls (42) fester Phase durch Kristallisierung einer flüssigen Phase (44) wobei folgendes vorgesehen ist:
ein Schmelzgefäß (40) welches in der Lage ist die feste Phase (42) und die flüssige Phase (44) zu enthalten, wobei die flüssige Phase in Kontakt mit dem Schmelzgefäß steht und die feste Phase vom Schmelzgefäß durch einen Zwischenraum (43) getrennt ist; und
Mittel zur Erhitzung der flüssigen Phase, die in der Lage sind einen thermischen Gradienten an dem Niveau einer Zwischenfläche (46) zwischen der flüssigen Phase und der festen Phase zu erzeugen,
**dadurch gekennzeichnet, dass** die Vorrichtung folgendes aufweist:
von den Heizmitteln unterschiedliche Elektromagnetfelderzeugungsmittel (50) um einen elektromagnetischen Druck an der Oberfläche der Verbindung (48) der flüssigen Phase anzulegen, und zwar auf dem Niveau der Zwischenfläche und wobei diese mindestens eine Schleife (50) das Schmelzgefäß umgebend aufweisen und zwar angeordnet vis ä vis zu der Zone, in der sich im Betrieb die Zwischenfläche bildet.

2. Vorrichtung nach Anspruch 1, wobei das Schmelzgefäß (40) in der Lage ist die flüssige Phase (44) zu enthalten und zwar angeordnet oberhalb der festen Phase (42), wobei die Vorrichtung ferner Mittel aufweist zum Anlegen eines ersten Gasdrucks an die Oberfläche der Verbindung (48) und eines zweiten Gasdrucks an eine freie Oberfläche der flüssigen Phase (44) entgegengesetzt zur festen Phase (42), wobei der erste Gasdruck größer ist als der zweite Gasdruck.

3. Verfahren zur Herstellung eines Einkristalls (42) fester Phase durch Kristallisieren einer flüssigen Phase (44) wobei die folgenden Schritte vorgesehen sind:
Vorsehen eines Schmelzgefäßes (40) welches die feste Phase (42) und die flüssige Phase (44) enthält, wobei die flüssige Phase (44) in Kontakt mit dem Schmelzgefäß steht und wobei die feste Phase von dem Schmelzgefäß durch einen Zwischenraum (43) getrennt ist;
Anlegen eines thermischen Gradienten am Niveau einer Zwischenfläche (46) zwischen der flüssigen Phase und der festen Phase; und
gleichzeitiges Anlegen eines elektromagnetischen Drucks über der gesamten Oberfläche der Verbindung (48) der flüssigen Phase an dem Niveau der erwähnten Zwischenfläche.

4. Verfahren nach Anspruch 3, wobei die flüssige Phase (44) oberhalb der festen Phase (42) angeordnet ist und wobei ein erster Gasdruck an der Oberfläche der Verbindung (48) und ein zweiter Gasdruck an einer freien Oberfläche der flüssigen Phase (44) angelegt wird und zwar entgegengesetzt zur festen Phase (42), wobei der erste Gasdruck größer ist als der zweite Gasdruck.
